# EUROPEAN PATENT SPECIFICATION

(11) **EP 2 184 594 B1**
(45) Date of publication and mention of the grant of the patent: **13.02.2019**
(21) Application number: 08168746.9
(22) Date of filing: 10.11.2008
(51) Int. Cl.: G01L 9/06

(54) **A pressure sensor for measuring pressure in a medium**
Drucksensor zur Druckmessung in einem Medium
Capteur de pression pour mesurer la pression dans un milieu

(30) Priority: 31.07.2008 US 137469 P
(43) Date of publication of application: 12.05.2010
(73) Proprietor: Sensata Technologies, Inc., Attleboro, MA 02703 (US)
(72) Inventor: Morsink, Frank Gerald Daniël, 7443 KG, Nijverdal (NL); Spijksma, Gerald Ivan, 7462 ZH, Rijssen (NL); te Boekhorst, Tom Bernard Henri, 7557 XM, Hengelo (NL); Mulligan, Sean Patrick, South Boston, MA 02127 (US); Bae, Jun, Chestnut Hill, MA 02467 (US)
(74) Representative: Nederlandsch Octrooibureau

(56) References cited:
- DE-A1-102007 029 356
- JP-A- 2006 343 276
- US-A- 5 741 975
- US-A1- 2006 027 025
- US-A1- 2006 288 793
- Laser Processing Technology (LPT), inc: "Design Guideline for Ceramic Substrates", , 19 August 2006 (2006-08-19), XP002612875, Retrieved from the Internet: URL:http://web.archive.org/web/20060819230 449/http://www.lpt-inc.com/designguide.htm l [retrieved on 2010-12-06]

## Description

### Field of the invention

The invention relates generally to hybrid electronics and more particularly to a pressure sensor module for use in a pressure sensor and more particularly to fluid pressure sensors exposed to acidic environments. The sensor module comprises a sensing element mounted on a front side of a support member. The support member comprises a hole through the support member from the front side to a back side and the sensing element covers the hole at the front side.

### Background of the invention

A pressure sensor module of the above-mentioned type is known from WO2002/079742. The known pressure sensor module is used in a gauge differential pressure configuration. Two identical sensor sensors modules are used to measure the pressure of two media. Each configuration comprises a hole. The hole passes through a substrate which is covered at one side by the sensing element. The other sides of both sensing elements see the same reference pressure, typically atmospheric pressure, due to the fact that they sit in the same chamber. An additional inlet can pass through the housing of the pressure sensor to provide atmospheric pressure to the chamber. In this open configuration, water vapor and other contaminants can freely enter the chamber.

The pressure media, designated as a low and a high pressure, enter the housing through separate pressure inlets and act upon the sensing elements via the hole through the substrate.

Furthermore, similar pressure sensors modules are known wherein the hole through the substrate is filled with an acid resistant gel to isolate the sensing element from contaminants and the acidic environment.

The through hole can be made with laser cutting. Laser cutting of through holes in ceramics is an economical process commonly implemented in hybrid electronics. However, the laser cutting process can damage the inherent acid robustness of the ceramic by creating micro cracks and/or forming more vulnerable phases of the ceramic (i.e. glassy phase) on the surface of the ceramic. When used in an acidic environment, such as diesel exhaust, the untreated laser cut surface may be prone to chemical attack and corrosion. This laser cut surface may be prone to chemical attack and corrosion even when the through holes are potted with a protective coating. This chemical attack and corrosion will change the properties of the protective coating which could result in malfunctioning of the pressure sensor.

American patent publication US2006/288793 discloses a pressure sensor module with a substrate having a sensor chip receiving external pressure via a through hole. A gel material is present in a concave portion and the through hole to protect the sensor chip.

German patent publication DE-A-10 2007 029356 discloses a differential pressure sensor having symmetrical sensor chips and pressure introduction channels.

Japanese patent publication JP-A-2006343276 discloses a sensor module having rounded corners in the member supporting a sensor element and being in contact with a protective gel.

### Summary of the invention

It is an object of the present invention to provide a pressure sensor module with improved robustness to acidic conditions such as those found in exhaust environments.

According to the present invention, a pressure sensor module according to claim 1 is provided.

It is noted that the article 'Design Guideline for ceramic Substrates' from Laser Processing technology (LPT), Inc. (available from Internet discloses in general an annealing process for ceramic substrates.

In an exemplary embodiment, the support member of the pressure sensor module further comprises a backside barrier at the backside of the support member, surrounding a surface of the backside of the support member including the hole and forming an enclosed area, wherein the enclosed area and the hole form a pressure channel and,
a backside protective member filling the hole and at least partially the enclosed area.

Legislation drives the need for a soot filter in exhaust systems of diesel powered engines used in passenger cars and commercial vehicles. Periodic regeneration of the soot filter is required when the filter gets clogged. For triggering this regeneration process and for satisfying On-Board Diagnostics (OBD) requirements, a pressure drop measurement over the filter is needed. This could be accomplished by a MEMS based differential pressure sensor. The sensing element of a MEMS based differential pressure sensor needs to be protected against the exhaust environment. For this reason a protective gel is used. This gel should provide mechanical isolation against deposits and offers protection of the sensing elements against damaged by frozen water. In the case of a front-side exposed sensing element, this is generally accomplished by placing a gel dam or barrier around the sensing element and filling the chamber formed by the gel dam with a protective gel. To protect the other side sensing element, the walls of hole through the support member are used as gel dam and the chamber formed by the hole is filled with a protective gel.

At one side of the sensing element is acting the exhaust pressure before the soot filter and at the other side of the sensing element is acting the exhaust pressure after the soot filter. It was assumed that the soot filter filters the exhaust so good that the exhaust after soot filter is less aggressive and a through hole filled with protective gel provides sufficient protection for the sensing element for the product life time. The amount of protective gel should be sufficient to protect the sensing element against chemical attacks. However, it has been found that despite the assumed less aggressive exhaust after the soot filter, the gel in the hole of the support at the backside degrades faster than the gel between the gel dam at the front side. The geometric constraints of the through hole are the cause of the faster degradation of the protective gel in the hole. It has been found the protective gel is polluted more near the walls of the hole than in the middle of the hole. The first degradations of the protective gel appear in the area near the point where the surfaces of the ceramics, exhaust and protective gel meet each other. One of the reasons is the structure of the surface of the hole due to the laser cutting process. Without a back side barrier, water pockets will occur in the gel in the narrow through hole. The water pockets comprise NOₓ-gasses. The water pockets introduce mechanical stress in the gel, which is subsequently acting on the sensing element. Over a longer period, the water pockets degrade the gel in a way that cracks and water bubbles occur in the gel, resulting in a malfunctioning sensor.

A similar degradation mechanism has also been observed in the gel protecting on the other side of the sensing element which is exposed to the exhaust pressure before the soot filter. However the degradation mechanism at this side is much slower, does not start at the edges and does not result in output failures.

According to the present invention, these problems are overcome by means of the backside barrier which is at least partially filled with a protective gel. This enlarges the distance between the surface of the gel exposed to exhaust gas and the walls of the hole. This ensures that water pockets in the gel will appear slower.

Furthermore, even if the gel is polluted, by means of particles or water pockets near the walls of the back side barrier, the effect on the performance of the sensor will be less, as the distance between opposite walls of the backside barrier is larger than the distance between the walls of the hole.

In an embodiment of the invention, a cross section of the hole widens from the back to the front of the support member and in another embodiment, the transition of the surface of the hole to the backside has a smooth shape. The gel is a viscous substance with a high coefficient of thermal expansion (CTE). A change in pressure of the exhaust gas has to be transferred to the sensing element without any loss of signal over a wide temperature range. In case of temperature changes, this feature reduces the mechanical resistance in the pressure channel, as the gel in the hole can expand or contract without creating too much stress on to the sensing element. This in return improves the accuracy and stability of the pressure sensor.

In an embodiment of the invention, the backside barrier is attached to the support member. This feature allows to construct the pressure channel by means of two economically to manufacture components, for example a ceramic printed wiring board (PWB) and a ceramic ring, which are glued together.

In another embodiment of the invention, the support member and backside barrier are formed by one piece of material, for example ceramic material. This allows to skip the manufacturing step of attaching the gel dam to the support member.

In another embodiment of the invention, the back side barrier is formed by a bead of adhesive.

In an embodiment of the invention, the support member is a ceramic PWB having an electrically conductive element provided at the front side and electrically connected to the sensing element. Preferably, the electrically conductive element comprises noble metals. This feature reduces the influence of acidic conditions due to the exhaust acting on the front-side. Using noble metals further improves the robustness of the conductive elements.

In an embodiment of the invention, the sensing element is a differential pressure sensing element. In a preferred embodiment, the sensing element is a Micro-ElectroMechanical Systems (MEMS) differential pressure sensing element. This feature allows us to provide an improved differential pressure sensor, which could be used to measure a pressure drop over for example a soot filter in an exhaust system.

In a further embodiment, the sensor further comprises a front side barrier surrounding the sensing element and a front side protective member which has an electrical insulating property and covers the sensing element and the front side between the front side barrier. These features provide a differential pressure sensor with improved robustness to acidic conditions present at both sides of the pressure sensor.

In an embodiment of the invention, the enclosed area on the backside within the backside barrier is larger then the area of the hole in the support member. This allows to fill the pressure channel with enough protection gel to reduce the forming and the effect of pollutants, which could be water pockets, in the gel in the through hole.

In an embodiment of the invention, wherein the minimum thickness of the backside protective member covering the sensing element is larger than the minimum distance between the surface of the sensing element covered by the backside protective member and a plane coinciding with the backside of the support member.

By adding a gel dam to the backside of the support member, optimizing the shape of the through hole, and filing the pressure channel with sufficient protective gel, the ratio of the gel surface versus gel height is increased, the distance between the gel surface and sensing element is increased, the distance between the position where the surface of the gel touches the side wall and the sensing element.

In an embodiment of the invention, edge conditions of the through hole have been improved by a method comprising the steps of:
increasing the temperature of the support at a selected rate from ambient temperature of approximately 25 deg C to approximately 1300 deg C +/- 100 deg C,
maintaining the temperature at approximately 1300 deg C for approximately one hour, and,
decreasing the temperature of the ceramic member at a selected rate to ambient temperature. This process converts a laser subjected surface from a more vulnerable surface texture and/or ceramic phase(s) to a more robust surface texture and/or phase(s) of the ceramic.

In yet another embodiment of the invention, support member is manufactured by means of a sintering process, wherein the hole in formed in the support member by means of a mold. It has been found that the edges of a through hole made by such a process have a less vulnerable surface texture than edges of a through hole made by a laser cutting process.

Another object of the invention is to provide an improved pressure sensor arrangement comprising a housing and a pressure sensor module according to the invention.

### Brief description of the drawings

The present invention will be discussed in more detail below, using exemplary embodiments, with reference to the attached drawings, in which
Fig. 1 shows cross sectional view of a pressure sensor module according to a preferred embodiment;
Fig. 2 shows cross sectional view of a pressure sensor arrangement according to a preferred embodiment;
Fig. 3 shows a perspective view of a pressure sensor module assembly;
Fig. 4 shows a top plane view of a ceramic substrate in which a plurality of individual ceramic support members have been laser cut and scribed for use in a pressure sensor module;
Fig. 5 shows a acid test result after an acid test on a standard laser cut through hole which is not subjected to an anneal process; and,
Fig. 6 shows a acid test result after an acid test on a through hole which is subjected to an anneal process and,
Fig. 7 illustrates some dimension requirements of the backside protective member.

### Detailed description of exemplary embodiments

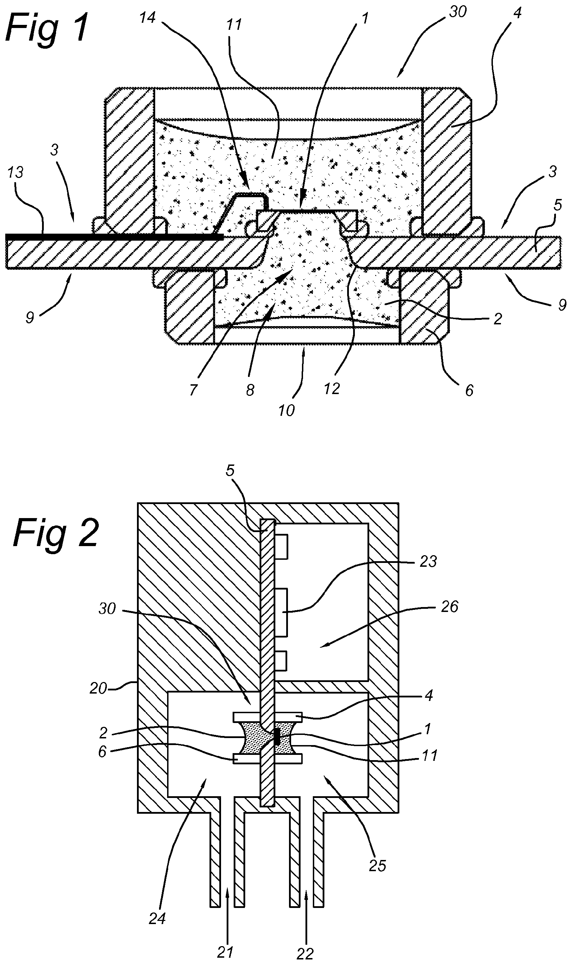

With reference to figures 1 and 2 and according to a preferred embodiment of the invention, a pressure sensor module for measuring fluid pressure in an acidic medium has a fluid pressure responsive sensing element 1 mounted on a front side 3 of a support member 5 over a through hole 7 and a backside barrier 6 or gel dam is disposed around the through hole on the opposite or back side of the support member. The barrier 6 and through hole 7 are filled with a backside protective member 2. This module is meant as a sub-assembly that has to be fit in a sensor housing before it can be used as a pressure sensor or device. Figure 2 shows a cross sectional view of pressure sensor arrangement comprising a pressure sensor module 30 according to a preferred embodiment. Figure 1 shows a cross sectional view of a part of the pressure sensor module shown in figure 2. A module 30 can be used as differential pressure sensor , for example, in an exhaust system to measure the pressure drop over a soot filter. The differential pressure is preferably measure by means of a MEMS differential pressure sensing element 1. Such sensors are known in the art. Alternatively, the sensing element 1 can have thin-film, foil gauge or bulk silicon gauge design.

The pressure sensor module 30 is preferably manufactured completely before it is placed in a housing 20 of the pressure sensor arrangement. The housing 20 and pressure sensor module 30 form a first pressure chamber 24 and a second pressure chamber 25. The housing comprises a first inlet 21 through which a first fluid having a first pressure can enter the first pressure chamber 24. The housing comprises further a second inlet 22 through which a second fluid having a second pressure can enter the second pressure chamber 25. The first fluid is for example the exhaust after the soot filter and the second fluid is the exhaust before the soot filter. The housing 20 further comprises a separate cavity 26 for accommodating sensor electronics. The cavity is separated from the first and second pressure chamber to isolate the components of the sensor electronics 23 from the acidic environment of the exhaust gasses.

The sensing element 1 is attached to a front side 3 of a support member 5 by means of a sealant or any other suitable adhesive material. The support member 5 is preferably made of a ceramic material for example a 96% AL₂O₃ ceramic material. Alternatively, a support member 5 of a purer AL₂O₃ ceramic or other suitable ceramic material could be used. The support member 5 comprises a through hole 7 from the front side 3 of the support member 5 to a backside 9 of the support member 5. The sensing element 1 hermetically covers the hole 7 at the front side 3, to form a seal between both sides of the support member 5. The through hole 7 can be made by means of laser cutting with a CO2 laser. A support with a through hole 7 can also be made by means of a sintering process. The hole 7 is then formed in the support member by means of an extrusion in the mold in a commonly known way. An advantage of forming the hole during the sintering process is that the hole comprises a less vulnerable surface texture and/or ceramic phase than when the hole is made by a laser cutting process.

Another way of creating a through hole 7 in the support is to stamp with a tool through the support prior to firing of the ceramic panel, so called green state punching.

In use, pressures are acting on both sides of the sensing element and the differential pressure results in a change in form of the membrane structure of the sensing element 1. This change in form causes a resistance change in gauges of the sensing elements, Which is amplified and conditioned by sensor electronics 23 mounted on the support member 5.

Wire bonds 14 electrically connect the sensing element 1 to electrically conductive elements, e.g. traces 13 on the support member 5. Preferably, the traces 13 and wire bonds 14 are made of noble metals to improve there characteristics with respect to chemical attack and corrosion due to the acidic environment created by the fluids present at both sides of the support member 5. The support member with electrically conductive elements form a ceramic Printed Wiring Board on which electronic components 23 can be adhered to form electronic circuitry 23. The electronic circuitry is arranged to sense one or more electrical properties of the sensing element and to condition and convert the one or more electrical properties into an output signal for use in the electronic control unit of the vehicle.

The pressure sensor module 30 comprises at the front side 3 of the support member 5 a front side barrier 4. The front side barrier 4 surrounds the sensing element 1 and forms a cavity which is partially filled with a front side protective member 11. The protective member 11 has an electrical insulating property and covers one side of the sensing element 1 and a part of the front side surface between the front side barrier 4. The protective member 11, which is preferably a gel, protects the sensing element 1 from contaminants introduced through the second inlet 22 in the second pressure chamber 25. The front side barrier 4 keeps the front side protective member 11 in place. A "gel" is defined as a colloidal suspension of a liquid in a solid, forming a jellylike material in a more solid form than a solution. The gel is specially selected to accurately transmit pressure in the pressure chamber while isolating the sensing element from harsh surrounding conditions. The gel can be, for example, Shin-Etsu Sifel, which stays soft over a -40°C - +135°C temperature range and does not exert additional pressure on the sensing element 1. The gel is preferably resistant to exhaust gasses. The protective member 2 protects the sensing element 1 from condensate of exhaust gasses, which is an acidic condensate. Furthermore, the protective member forms a mechanical isolator for soot particles and other particles that could damage the sensing element 1 and/or could make the sensing element 1 malfunctioning.

The pressure sensor module 30 further comprises at the backside 3 of the support member 5 a backside barrier 6. The backside barrier 6 surrounds the through hole 7 and forms an enclosed area 8 which is partially filled with a back side protective member 2. The backside protective member 2 is a similar substance as the front side protective member 11 having similar properties. The backside protective member 2, which is preferably a gel, protects the sensing element 1 from contaminants introduced through the first inlet 22 in the first pressure chamber 24. The backside barrier 6 keeps the backside protective member 2 in place.

The hole 7 and enclosed area 8 surrounded by the backside barrier 6 form a pressure channel 10. The pressure channel 10 allows to transfer a pressure in the first pressure chamber 24 to act on the sensing element 1.

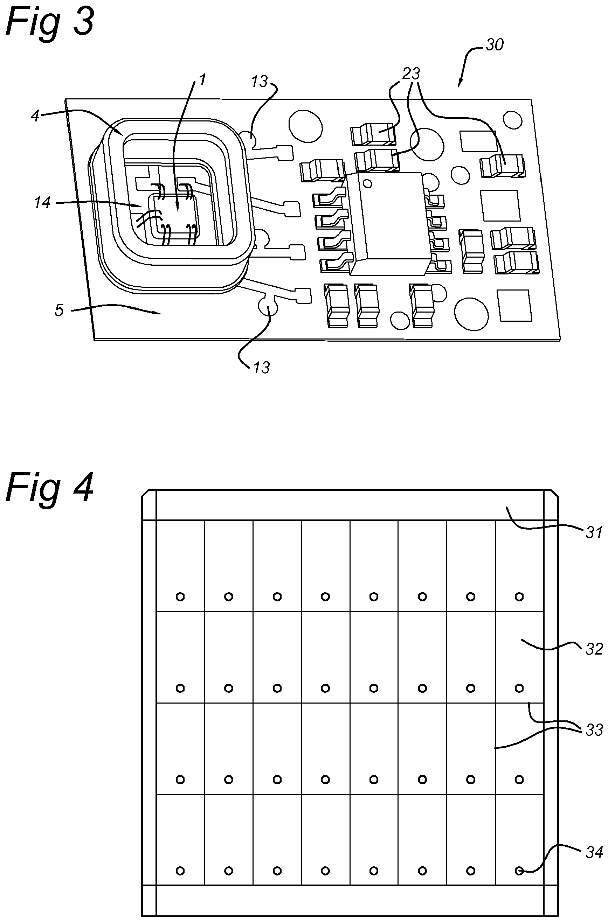

The front side barrier 4 and backside barrier 6 can be surrounding structure. The shape of the surrounding structure can be substantially squared as illustrated in figure 3, substantially cylindrical, or can have any other suitable shape. The barriers 4, 6 are preferably made of the same material as the support member 5. The barriers are preferably made of a ceramic material.

The front side barrier 4 is a structure which is bonded to the support member after the conductive elements 13 or traces are etched on the support member 5. The backside barrier 6 can be a structure which is bonded on the support member 5. In another embodiment, the support member 5 and the backside barrier 6 are formed by one piece of material, for example by means of sintering process.

The front and back side barrier 4, 6 can be a solid member, 96% alumina for example, or an elastomer (flexible member), such as dispensed Sifel 604 adhesive. In case of an elastomer, the barriers 4, 6 can be processed in a discrete dispense and cure step or co-cured with the respective protective members 2, 11.

The through hole 7 in the support member 5 can have edges which are parallel to each other and perpendicular to both the front side 3 and backside 9 of the support member 5. According to the invention, the area of the surface of the backside 9 of the support member 5 encompassed by the backside barrier 6 is larger than the area of the through hole 7 in the surface of the backside 9 of the support member 5. A change in temperature will result in expansion or contraction of the protective member 2 in the pressure channel 10. Adhesion of protective member 2 to the side walls will result in stress due to the thermal expansion or contraction. The shape of a transition surface 12 from the backside surface 9 of the support member 5 to the surface of the through hole 7 will determine the transfer of thermal stress to the sensing element 1.

The thermal stress of the protective member 2 in the pressure channel 10 formed by the through hole 7 and enclosed area 8 of the backside barrier 6 could further be improved by having a through hole 7 which cross section widens from the front side 3 to the backside 9, in other words which cross section widens with increases of distance from the sensing element 1. This feature has further the advantage that it provides a pressure channel which introduces less mechanical stress on the sensing element 1 due to different temperature dependent coefficients of expansion of the used materials.

Figure 3 shows a perspective view of the front side of a pressure sensor module assembly 30. On the front side of the support member 5 is the sensing element 1. The support member is a ceramic PWB on which conductive elements or traces 13 are etched. The sensing element 1 is electrically connected to conductive elements 13 by means of bonding wires 14. A front side barrier 4 is attached to the front side of the support member 5. The conductive elements 13 pass under the front side barrier 4 to electronic circuitry 23 for converting electrical signals obtained from the sensing element 1 into a signal indicative of the measured differential pressure.

Fig. 4 shows a top plane view of a ceramic substrate 31 in which a plurality of individual ceramic support members 32 have been laser cut and scribed for use in a pressure sensor module as shown in figures 1 - 3. The ceramic substrate is suitable for batch processing. References 33 indicate laser scribe lines for separating of the individual ceramic support members 32. Each individual support member 32 comprises a through hole 34 in the ceramic. The through hole 34 is provided for accessing application pressure to reach a sensing element surface that covers the through hole 34 at one side of the ceramic support member 32.

The through holes 34 can be formed there through by laser processing or green state forming, wherein the hole 34 is formed during a sintering process forming the ceramic substrate 31.

According to a further embodiment of the invention, ceramic edge conditions of a ceramic member are changed to improve the robustness to acid for use in acidic environments such as diesel engine exhaust by subjecting the ceramic member to an annealing process to anneal (temperature and time) the laser cut surface to convert the laser subjected surface from the more vulnerable surface texture and/or ceramic phase(s) to more robust surface texture and/or phase(s) of the ceramic.

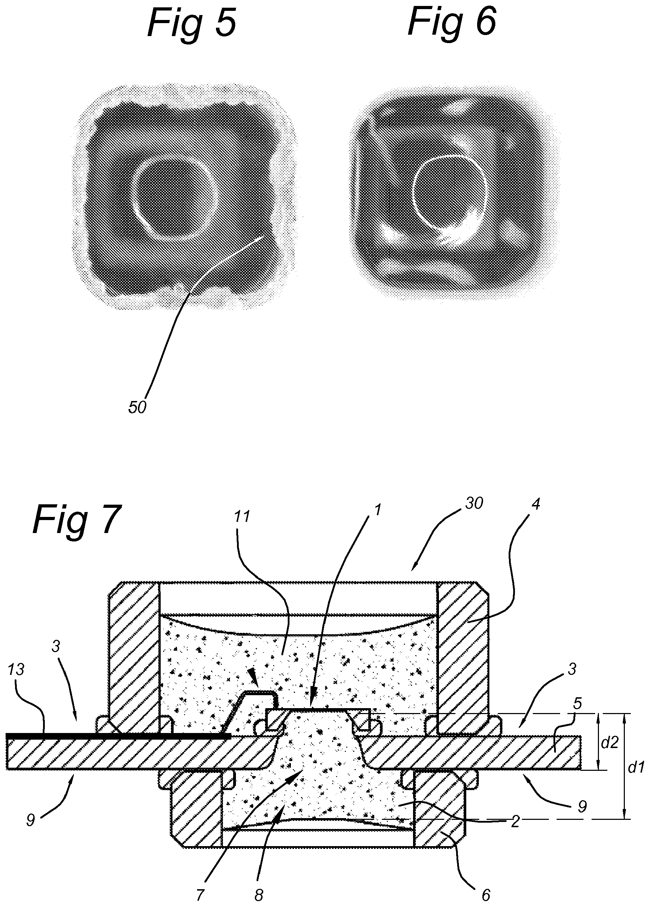

Figure 5 shows a view of one ceramic member having a standard laser cut through hole processed without annealing after being subjected to an acid test that shows evidence 50 of chemical attack on the edges of the ceramic member.

Ceramic substrate members can be formed as follows:
Take 96% Al₂0₃ ceramic substrate member (tape cast or roll compacted).

Emulsion applied to control slag produced in laser cutting process.

Through hole formation processed in the ceramic substrate member (laser cutting with CO2 laser).

Scribe formation processed in the ceramic substrate member for singularization at a later stage (pulsed laser cutting with CO2 laser).

Rinsed to remove emulsion.

The annealing process comprises the following steps:
Ramp from ambient (25 deg C) to annealing temperature following typical 35 deg C/min.
Annealing temperature: 1300 deg C +/- 100 deg C.
Oxygen environment: ambient air is sufficient.
Time for annealing: minimum of one hour.
Ramp from annealing temperature to ambient temperature following typical 35 deg C/min.

After the annealing process the following steps are performed to attach the conductive elements, i.e. traces, and electronic circuitry on the support member:
Thick film printing:
Screen print a first conductor.
First conductor dried.
First conductor fired at 850 deg C +/- 50 deg C.
Screen print a second conductor.
Second conductor dried.
Second conductor fired at 850 deg C +/- 50 deg C
Screen print dielectric thick film.
Dielectric thick film dried.
Dielectric thick film fired at 850 deg C +/- 50 deg C.
Sensor is then assembled.

Samples were made according to the above described processes and subjected to acid tests along with other conventional samples not subjected to an annealing process as follows.

### Test samples:

Control sample: Standard laser cut through hole formed in 96% alumina ceramic substrate members with MEMS die attached and Sifel (a registered trademark of Shin-Etsu for electronic potting material) 8070 gel filled in backside of the ceramic through hole/backside of the MEMS die.

Annealed test sample: Standard laser cut through hole formed in ceramic substrate member as in control sample but which was additionally subjected to 1300 deg C for one hour as described above. MEMS die attached and Sifel 8070 gel filled in backside of the ceramic through hole/backside of the MEMS die.

### Test conditions were as follows:

Test samples were immersed in a jar of 1.0 pH acid mixture comprising mainly nitric, sulfuric, acetic and formic acids. The samples were thermally cycled in the jar four times from 25 deg C to 95 deg C back to 25 deg C with one hour dwell at 95 deg C over a total time period of 120 hours. Samples were removed from the acid, rinsed, inspected and images captured as shown in figures 5 and 6.

Figure 6 shows a view of a ceramic member also having a standard laser cut through hole but processed with post annealing to improve the surface texture and/or promote the development of more acidic robust phase formation of the ceramic and showing no evidence of chemical attack on the edges of the ceramic member after being subjected to the same acid test.

In place of a temperature annealing process, a secondary machining operation, chemical etching or chemical treatment may be employed to improve surface texture and/or remove or reduce the more vulnerable phases of the ceramic member. Green state forming of the through hole in place of laser cutting may also be used with or without a secondary annealing, machining, chemical etching or other chemical treatment to prevent or reduce the formation of the more vulnerable phases of the ceramic member.

Figure 7 illustrates dimension requirements with respect to the protective member 2 at the backside 9 of the support member 5. The protective member 2 has a concave meniscus in response to the surface of the back side barrier 6. The bottom of the meniscus defines the minimum thickness d1 of the protective member with respect to the sensing element 1. In other words d1 is the minimum distance between the exhaust gas and the surface of the sensing element at the backside 9 through the protective member 2. Furthermore, distance d2 is the minimum distance between the surface of the sensing element 1 covered by the backside protective member 2 and a plane coinciding with the backside of the support member 9. It has been found that an attack by the exhaust gasses on the protective member 2 in the through hole 7, i.e. the presence of water pockets is reduced significantly if the minimum thickness d1 is equal to or larger than d2. This requirement ensures that the surface of the backside 9 of the support member 5 between backside barrier 6 is covered with some protective gel. As the first indications of degradation of the protective member are found in the protective member 2 near the position where meniscus touches the backside barrier, it will take more time before the protective member in the through hole 7 is degraded. This extends the lifetime of the pressure sensor.

The above described embodiments relate to a differential pressure sensor module. It should be noted, that the invention could be used to provide an improved acid-resistant pressure sensor. In that case a pressure sensor arrangement can comprises only the first pressure chamber 24 having an inlet 21 to allow a pressurized acidic fluid to access the first pressure chamber 24. The pressure is acting through the through hole 7 on one side of the sensing element 1. A predefined and conditioned pressure is acting on the other side of the sensing element. This predefined and conditioned pressure is from a non-acidic environment. This allows us to use less expensive materials for the bonding wires 14 and electrically conductive elements 13. Furthermore, no front side barrier 4 and front side protective member 11 is needed to protect the front side 3 of the pressure sensor module 30 for an acidic and contaminated environment. Such a pressure sensor module has the advantage that it can be manufactured and tested before it is finally placed in a sensor housing.

Disclosed is an alternative geometry of a pressure channel or gel chamber on the backside of a sensor module. The alternative geometry provides an improved pressure sensor module with improved robustness to acidic conditions on the backside of the sensor module. This is accomplished by adding a gel dam or barrier to the backside of the support member and optimizing the shape and/or dimensions of the pressure channel and the amount of gel. The gel dam enables us 1) to increase the ratio of the gel surface versus the gel height, i.e. the minimum distance between the exhaust gas and the sensing element, 2) to increase the distance between the meniscus and the sensing element, 3) to increase the distance between the points where the meniscus of the gel touches the side wall of the pressure channel and the sensing element, and 4) to eliminate possible nucleation sites in the gel in the through hole. Each of these improves the robustness of the pressure sensor module to acidic conditions such as those found in exhaust environments.

Several embodiments of the invention have been described above by way of exemplary embodiments. Various modifications and variations for the elements described with respect of these embodiments may be made by the skilled person without departing from the scope of the present invention, which is defined by the appended claims.

## Claims

1. A pressure sensor module for use in a pressure sensor, the pressure sensor module comprising:
a sensing element (1) mounted on a front side (3) of a support member (5);
the support member (5) comprising a hole (7) through the support member (5) from the front side (3) to a back side (9) and the sensing element (1) covering the hole (7) at the front side (3);
a backside barrier (6) at the backside (9) of the support member (5), surrounding a surface of the backside (9) of the support member (5) and forming an enclosed area (8), wherein the enclosed area (8) and the hole (7) form a pressure channel (10); and,
a backside protective member (2) filling the hole (7) and at least partially the enclosed area (8), **characterised in that**
the transition (12) of the surface of the hole (7) through the support member (5) to the backside (9) thereof is smooth, and
the support member (5) is a ceramic PWB having an electrically conductive element (13) provided at the front side (3) and electrically connected to the sensing element (1)..

2. The pressure sensor module according to claim 1, wherein a cross section of the hole (7) widens from the front side (3) to the backside (9).

3. The pressure sensor module according to any of the claims 1 - 2, wherein the backside barrier (6) is attached to the support member (5).

4. The pressure sensor module according to any of the claims 1 - 3, wherein the support member (5) and backside barrier (6) are formed by one piece of material.

5. The pressure sensor module according to any of the preceding claims, wherein the electrically conductive element (13) comprises noble metals.

6. The pressure sensor module according to any of the preceding claims, wherein the sensing element (1) is a differential pressure sensing element.

7. The pressure sensor module according to any of the preceding claims, wherein the sensing element (1) is a MEMS differential pressure sensing element.

8. The pressure sensor module according to claim 6, wherein the sensor further comprises:
a front side barrier (4) surrounding the sensing element (1); and
a front side protective member (11) which has an electrical insulating property and covers the sensing element (1) and the front side between the front side barrier (4).

9. The pressure sensor module according to any of the preceding claims, wherein the enclosed area (8) on the backside (9) within the backside barrier (6) is larger then the area of the hole (7) in the support member (5).

10. The pressure sensor module according to any of the preceding claims, wherein the minimum thickness (d1) of the backside protective member (2) covering the sensing element (1) is larger than the minimum distance (d2) between the surface of the sensing element (1) covered by the backside protective member (2) and a plane coinciding with the backside of the support member (9).

11. The pressure sensor module according to any of the preceding claims, wherein edge conditions of the through hole (7) have been improved by a method comprising the steps of:
increasing the temperature of the support at a selected rate from ambient temperature of approximately 25 deg C to approximately 1300 deg C +/- 100 deg C,
maintaining the temperature at approximately 1300 deg C for approximately one hour, and,
decreasing the temperature of the ceramic member at a selected rate to ambient temperature.

12. The pressure sensor module according to any of the preceding claims, wherein the support member (5) is manufactured by means of an injection molding process, wherein the hole (7) is formed in the support member (5) by means of a mold.

13. A pressure sensor arrangement comprising a housing (20) and a pressure sensor module (30) according to any of the preceding claims.

## Patentansprüche

1. Drucksensormodul zur Verwendung in einem Drucksensor, wobei das Drucksensormodul umfasst:
ein Sensorelement (1), das an einer Vorderseite (3) eines Trägerelements (5) montiert ist;
wobei das Trägerelement (5) ein Loch (7) durch das Trägerelement (5) von der Vorderseite (3) zu einer Rückseite (9) umfasst und das Sensorelement (1) das Loch (7) an der Vorderseite (3) abdeckt;
eine rückseitige Barriere (6) an der Rückseite (9) des Trägerelements (5), die eine Oberfläche der Rückseite (9) des Trägerelements (5) umrandet und einen geschlossenen Bereich (8) bildet, wobei der geschlossene Bereich (8) und das Loch (7) einen Druckkanal (10) bilden und
ein rückseitiges Schutzelement (2), das das Loch (7) und zumindest teilweise den eingeschlossenen Bereich (8) füllt, **dadurch gekennzeichnet, dass** der Übergang (12) der Oberfläche des Lochs (7) zur Rückseite (9) sanft ist, und
wobei das Trägerelement (5) ein keramisches PWB (gedruckte Leitplatte) mit einem elektrisch leitfähigen Element (13) ist, das an der Vorderseite (3) vorgesehen und elektrisch mit dem Sensorelement (1) verbunden ist.

2. Drucksensormodul nach Anspruch 1, wobei sich ein Querschnitt des Lochs (7) von der Vorderseite (3) zu der Rückseite (9) erweitert.

3. Drucksensormodul nach einem der Ansprüche 1-2, wobei die rückseitige Barriere (6) an dem Trägerelement (5) befestigt ist.

4. Drucksensormodul nach einem der Ansprüche 1-3, wobei das Trägerelement (5) und die rückseitige Barriere (6) aus einem Stück Material gebildet sind.

5. Drucksensormodul nach einem der vorhergehenden Ansprüche, wobei das elektrisch leitfähige Element (13) Edelmetalle umfasst.

6. Drucksensormodul nach einem der vorhergehenden Ansprüche, wobei das Sensorelement (1) ein Differenzdruck-Sensorelement ist.

7. Drucksensormodul nach einem der vorhergehenden Ansprüche, wobei das Sensorelement (1) ein MEMS-Differenzdrucksensorelement ist.

8. Drucksensormodul nach Anspruch 6, wobei der Sensor ferner Folgendes umfasst:
eine vorderseitige Barriere (4), die das Sensorelement (1) umrandet und
ein vorderseitiges Schutzelement (11), das eine elektrisch isolierende Eigenschaft aufweist und das Sensorelement (1) und die Vorderseite zwischen der vorderseitigen Barriere (4) abdeckt.

9. Drucksensormodul nach einem der vorhergehenden Ansprüche, wobei der geschlossene Bereich (8) auf der Rückseite (9) innerhalb der rückseitigen Barriere (6) größer ist als der Bereich des Lochs (7) in dem Trägerelement (5).

10. Drucksensormodul nach einem der vorhergehenden Ansprüche, wobei die minimale Dicke (d1) des das Sensorelement (1) abdeckenden rückseitigen Schutzelements (2) größer ist als der minimale Abstand (d2) zwischen der Oberfläche des Sensorelements (1), das durch das rückseitige Schutzelement (2) abgedeckt ist, und einer Ebene, die sich mit der Rückseite des Trägerelements (9) deckt.

11. Drucksensormodul nach einem der vorhergehenden Ansprüche, wobei die Kanteneigenschaften des Durchgangslochs (7) durch ein Verfahren verbessert wurden, das die folgenden Schritte umfasst:
Erhöhen der Temperatur des Trägers mit einer ausgewählten Geschwindigkeit von einer Umgebungstemperatur von etwa 25°C auf etwa 1300°C +/- 100°C,
Halten der Temperatur bei etwa 1300°C für etwa eine Stunde und
Verringern der Temperatur des Keramikelements mit einer ausgewählten Geschwindigkeit auf die Umgebungstemperatur.

12. Drucksensormodul nach einem der vorhergehenden Ansprüche, wobei das Trägerelement (5) mittels eines Spritzgussverfahrens hergestellt ist, wobei das Loch (7) in dem Trägerelement (5) mittels einer Form ausgebildet ist.

13. Drucksensoranordnung, umfassend ein Gehäuse (20) und ein Drucksensormodul (30) nach einem der vorhergehenden Ansprüche.

## Revendications

1. Un module capteur de pression destiné à être utilisé dans un capteur de pression, le module capteur de pression comprenant:
- un élément de détection (1) monté sur une face avant (3) d'un élément de support (5);
- l'élément de support (5) comprenant un trou (7) traversant l'élément de support (5) depuis le côté avant (3) jusqu'à un côté arrière (9) et l'élément de détection (1) recouvrant le trou (7) du côté avant (3);
- une barrière arrière (6) disposée à l'arrière (9) de l'élément de support (5), entourant une surface de l'arrière (9) de l'élément de support (5) et formant une zone fermée (8), dans laquelle la zone fermée (8) et le trou (7) forment un canal de pression (10); et
- un élément de protection arrière (2) remplissant le trou (7) et au moins partiellement la zone fermée (8),
ce module étant **caractérisé en ce que**
▪ la transition (12) de la surface du trou (7) traversant l'élément de support (5) vers l'arrière (9) est progressive, et
▪ l'élément de support (5) est un PWB en céramique ayant un élément électriquement conducteur (13) prévu sur le côté avant (3) et connecté électriquement à l'élément de détection (1).

2. Le module de capteur de pression selon la revendication 1, dans lequel une section transversale du trou (7) s'élargit du côté avant (3) au côté arrière (9)..

3. Le module de capteur de pression selon l'une quelconque des revendications 1-2, dans lequel la barrière arrière (6) est fixée à l'élément de support (5).

4. Le module de capteur de pression selon l'une quelconque des revendications 1 à 3, dans lequel l'élément de support (5) et la barrière arrière (6) sont formés par une seule pièce de matériau.

5. Le module capteur de pression selon l'une quelconque des revendications précédentes, dans lequel l'élément électriquement conducteur (13) comprend des métaux nobles.

6. Le module de capteur de pression selon l'une quelconque des revendications précédentes, dans lequel l'élément de détection (1) est un élément de détection de pression différentielle.

7. Le module de capteur de pression selon l'une quelconque des revendications précédentes, dans lequel l'élément de détection (1) est un élément de détection de pression différentielle MEMS.

8. Le module de capteur de pression selon la revendication 6, dans lequel le capteur comprend en outre:
- une barrière latérale avant (4) entourant l'élément de détection (1); et
- un élément de protection côté avant (11) qui a une propriété isolante électrique et recouvre l'élément de détection (1) et le côté avant entre la barrière latérale avant (4).

9. Le module de capteur de pression selon l'une quelconque des revendications précédentes, dans lequel la zone fermée (8) à l'arrière (9) à l'intérieur de la barrière arrière (6) est plus grande que la surface du trou (7) dans l'élément de support (5)..

10. Le module capteur de pression selon l'une quelconque des revendications précédentes, dans lequel l'épaisseur minimale (d1) de l'élément de protection arrière (2) recouvrant l'élément de détection (1) est supérieure à la distance minimale (d2) entre la surface de l'élément de détection (1) recouvert par l'élément de protection arrière (2) et un plan coïncidant avec l'arrière de l'élément de support (9).

11. Le module de capteur de pression selon l'une quelconque des revendications précédentes, dans lequel les conditions de bord du trou traversant (7) ont été améliorées par un procédé comprenant les étapes consistant à:
- augmenter la température du support à un taux sélectionné de la température ambiante d'approximativement 25°C à environ 1300°C +/- 100°C,
- maintenir la température à environ 1300°C pendant environ une heure et
- abaisser la température de l'élément en céramique à une vitesse choisie jusqu'à la température ambiante.

12. Le module de capteur de pression selon l'une quelconque des revendications précédentes, dans lequel l'élément de support (5) est fabriqué au moyen d'un procédé de moulage par injection et dans lequel le trou (7) est formé dans l'élément de support (5) au moyen d'un moule.

13. Agencement de capteur de pression comprenant un boîtier (20) et un module de capteur de pression (30) selon l'une quelconque des revendications précédentes.
